# EUROPEAN PATENT SPECIFICATION

(11) **EP 1 296 154 B1**
(45) Date of publication and mention of the grant of the patent: **23.02.2005**
(21) Application number: 02021727.9
(22) Date of filing: 25.09.2002
(51) Int. Cl.: G01R 31/3185

(54) **Semiconductor integrated circuit**
Integrierte Halbleiterschaltung
Circuit intégré à semi-conducteur

(30) Priority: 25.09.2001 JP 2001292093
(43) Date of publication of application: 26.03.2003
(73) Proprietor: Kabushiki Kaisha Toshiba, Tokyo 105-8001 (JP)
(72) Inventor: Kamei, Takayuki, 1-1-1, Shibaura, Minato-ku, Tokyo (JP); Urakawa, Yukihiro, 1-1-1, Shibaura, Minato-ku, Tokyo (JP)
(74) Representative: HOFFMANN - EITLE

(56) References cited:
- EP-A- 0 073 602
- EP-A- 1 291 662
- WO-A-01/39163
- US-A- 5 907 671
- US-A- 5 923 512
- US-A- 6 065 141
- PATENT ABSTRACTS OF JAPAN vol. 2000, no. 21, 3 August 2001 (2001-08-03) & JP 2001 101896 A (TOSHIBA CORP), 13 April 2001 (2001-04-13)

## Description

### BACKGROUND OF THE INVENTION

### Field of the Invention

The present invention relates to a semiconductor integrated circuit having a scan path.

### Related Background Art

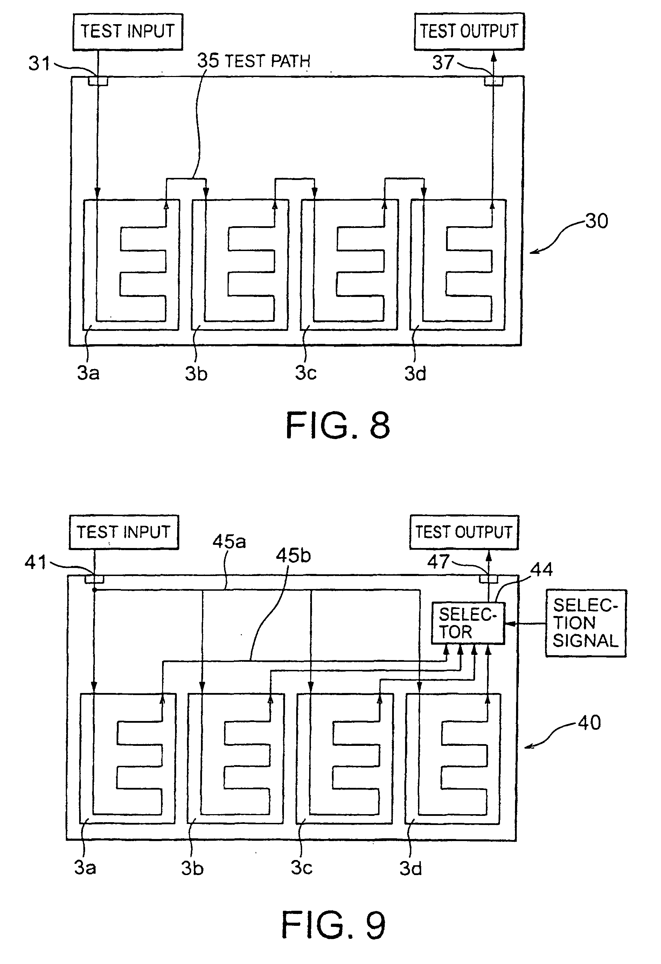

Conventionally, as shown in Fig. 8, in a semiconductor integrated circuit 30 including a plurality of the same logic circuits 3a, 3b, 3c, and 3d, such as a graphic processor, a test path (scan path) 35 connecting in series latch circuits (not shown) of the logic circuits 3a, 3b, 3c, and 3d is provided, so that the logic circuits can be tested. In the test, first a serial test pattern is created and inputted to a test input terminal 31 of the semiconductor integrated circuit 30 to set a value in the latch circuits. Then, the clock is advanced by one, to change the value of the logic circuits. Thereafter, the value of the latch circuits is outputted from a test output terminal 37 of the semiconductor integrated circuit 30 and compared with an expected value. If the outputted value is different from the expected value, a failure of the semiconductor integrated circuit 30 can be detected. In this way, it is possible to carry out a test with a smaller number of test terminals 31, 37 and to automatically generate an input pattern and an expected value.

However, as the size of logic circuits to be tested increases, it becomes to take much time to carry out a test if all of the latch circuits are connected in series with a single test path. Further, the size of the test pattern and the amount of the expected value are increased, thereby exhausting the memory, in which the test pattern is stored, of the test device. In order to solve this problem, in a semiconductor integrated circuit 40 shown in Fig. 9, a selector 44 is provided for branching the test path connecting the test input terminal 41 and the test output terminal 47 via the logic circuits 3a, 3b, 3c, and 3d into the test paths 45a and 45b passing in parallel through the logic circuits 3a, 3b, 3c, and 3d. When a test is carried out for the semiconductor integrated circuit 40, the path to be tested is switched by inputting a selection signal to the selector 44. Then, a test pattern is inputted.

In the semiconductor integrated circuit 40 shown in Fig. 9, it is possible to reduce the size of the test pattern, thereby reducing the capacity of the memory required for storing the test pattern since the input pattern and the expected value are inputted for each of the test paths (i.e., for each of the logic circuits).

However, in the semiconductor integrated circuit shown in Fig. 9, all of the paths should be sequentially tested. Therefore, it is not possible to reduce the time required for the test.

EP-A-0073602 discloses a system comprising a plurality of parallel replicated sub-systems the outputs of which are combined by a majority voter to provide a single consolidated output and sub-system output coincidence checking means to assure integrity of the consolidated output, wherein the coincidence checking means comprises apparatus in each sub-system channel connected to receive the outputs of all channels and arranged to perform a coincidence checking function and to provide an output to operate a fault indicator in the event of lack of coincidence with the majority, and apparatus for combining the fault indications relating to each sub-system to provide a single consolidated output declaring the integrity of each sub-system channel. Further, a coincidence checking block is proposed, arranged to generate outputs corresponding to each of the sub-systems, which outputs occupy a first state if the respective sub-system agrees with the majority or the sub-systems are unanimous and a second state if it disagrees with the majority. EP-A-0073602 is not related to a semiconductor integrated circuit.

### SUMMARY OF THE INVENTION

It is an object of the present invention to provide a semiconductor integrated circuit enabled to be reliably tested within short testing time. The chip size of a part of a testing equipment necessary on a integrated circuit under test should be kept small.

To solve this objects the present invention provides a semiconductor integrated circuit having the features as defined in claim 1. Preferred embodiments are subject to dependent claims.

### BRIEF DESCRIPTION OF THE DRAWINGS

Fig. 1 is a block diagram showing the structure of a semiconductor integrated circuit according to the first embodiment not showing all the necessary features of the present invention.
Fig. 2 is a block diagram showing the structure of a semiconductor integrated circuit according to the second embodiment not showing all the necessary features of the present invention.
Fig. 3 is a block diagram showing the structure of a semiconductor integrated circuit according to the third embodiment of the present invention.
Fig. 4 is a block diagram showing the structure of a semiconductor integrated circuit according to the fourth embodiment not showing all the necessary features of the present invention.
Fig. 5 is a circuit diagram showing the structure of a comparator of the semiconductor integrated circuit of the fourth embodiment.
Fig. 6 is a block diagram showing the structure of a semiconductor integrated circuit according to the fifth embodiment which does not show all necessary features of the present invention.
Fig. 7 is a block diagram showing the structure of a semiconductor integrated circuit according to the sixth embodiment not showing all the necessary features of the present invention.
Fig. 8 is a block diagram showing the structure of a conventional semiconductor integrated circuit.
Fig. 9 is a block diagram showing the structure of another conventional semiconductor integrated circuit.

### DESCRIPTION OF THE EMBODIMENTS

Hereinafter, the embodiments of the present invention will be described with reference to the accompanying drawings.

### (First Embodiment)

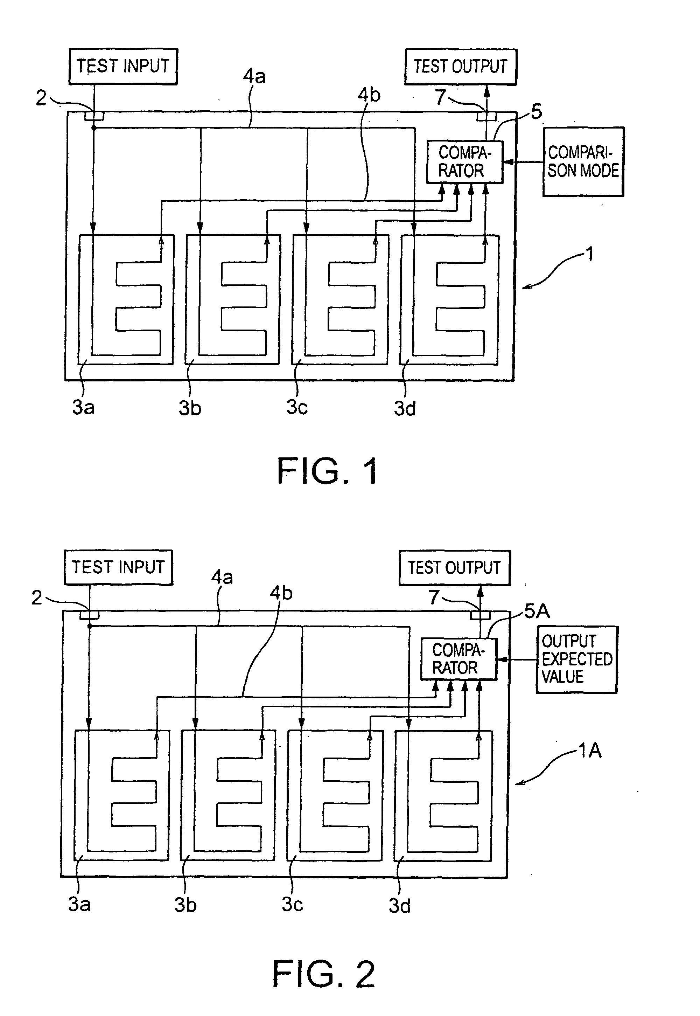

Fig. 1 shows the structure of a semiconductor integrated circuit according to the first embodiment not showing all the necessary features of the present invention. A semiconductor integrated circuit 1 of this embodiment includes a test input terminal 2, circuits to be tested having the same structure, e.g., logic circuits 3a, 3b, 3c, and 3d, a comparator 5, a test output terminal 7, and test paths 4a and 4b. A test pattern inputted through the test input terminal 2 is sent to each of the logic circuits 3a, 3b, 3c, and 3d via the test path 4a. Further, the test output from each of the logic circuits 3a, 3b, 3c, and 3d is sent to the comparator 5 via the test path 4b. Thus, the test path is branched into paths passing through the logic circuits 3a, 3b, 3c, and 3d.

The comparator 5 selects whether the test result of any one of the logic circuits 3a, 3b, 3c, and 3d, or the result of comparison of test results of the logic circuits 3a, 3b, 3c, and 3d should be outputted through the test paths 4b, based on an input of comparison mode. The output of the comparator 5 is outputted to the outside via the test output terminal 7 of the semiconductor integrated circuit 1.

Next, the operation of the semiconductor integrated circuit 1 according to the first embodiment at the time of carrying out a test will be described. First, the comparison mode to be inputted into the comparator 5 is set to the one "select any one of the test paths and output the test output of the selected test path as it is." Then, a test is carried out in the same manner as the case of the conventional semiconductor integrated circuit shown in Fig. 9. That is, the test output sent from the test output terminal is compared with an output expected value in the outside. Thus, the selected one test path (logic circuit) is tested. It is possible to determine whether there is a failure in the selected one test path (logic circuit) or not. If the test path is determined to have a failure, the semiconductor integrated circuit 1 is determined to be a defective. If the test path is determined not to have any failure, the following test is carried out.

The comparison mode is set to the one "output the comparison result", and then a test pattern is inputted. Since the test paths 4a and 4b are branched to pass through the logic circuits 3a, 3b, 3c, and 3d, the test outputs of the logic circuits 3a, 3b, 3c, and 3d should be the same for the same test pattern inputted from the test input terminal 2 of the semiconductor integrated circuit 1 if all of the logic circuits 3a, 3b, 3c, and 3d are normal. Accordingly, it is not necessary to compare all of the test paths with the expected value if the outputs of the test paths passing through the logic circuits 3a, 3b, 3c, and 3d are compared with each other in the comparator.

Thus, if there are a plurality of circuits (for example, logic circuits) having the same structure in a semiconductor integrated circuit, it is possible to test all of the circuits during the same time period as that required for testing two circuits. Moreover, if the comparison mode is selected, it is not necessary to prepare an expected output value. Accordingly, it is possible to save the capacity of the memory storing the test pattern.

### (Second Embodiment)

Next, the structure of a semiconductor integrated circuit according to the second embodiment not showing all the necessary features of the present invention is shown in Fig. 2. A semiconductor integrated circuit 1A of this embodiment is achieved by replacing the comparator 5 of the semiconductor integrated circuit 1 of the first embodiment shown in Fig. 1 with a comparator 5A. The comparator 5A is adjusted to simultaneously compare an inputted output expected value and the test outputs sent from the logic circuits 3a, 3b, 3c, and 3d, to determine whether the inputted output expected value and the test outputs are the same or not, and to output the comparison results. It is possible to carry out the tests of all of the logic circuits 3a, 3b, 3c, and 3d at a time by inputting the test pattern into the comparator 5A at the same time as the test outputs from the logic circuits 3a, 3b, 3c, and 3d are inputted into the comparator 5A. In this way, it is possible to further reduce the time required for the test, as compared with the first embodiment. In addition, it is also possible to save the capacity of the memory storing the test pattern.

### (Third Embodiment)

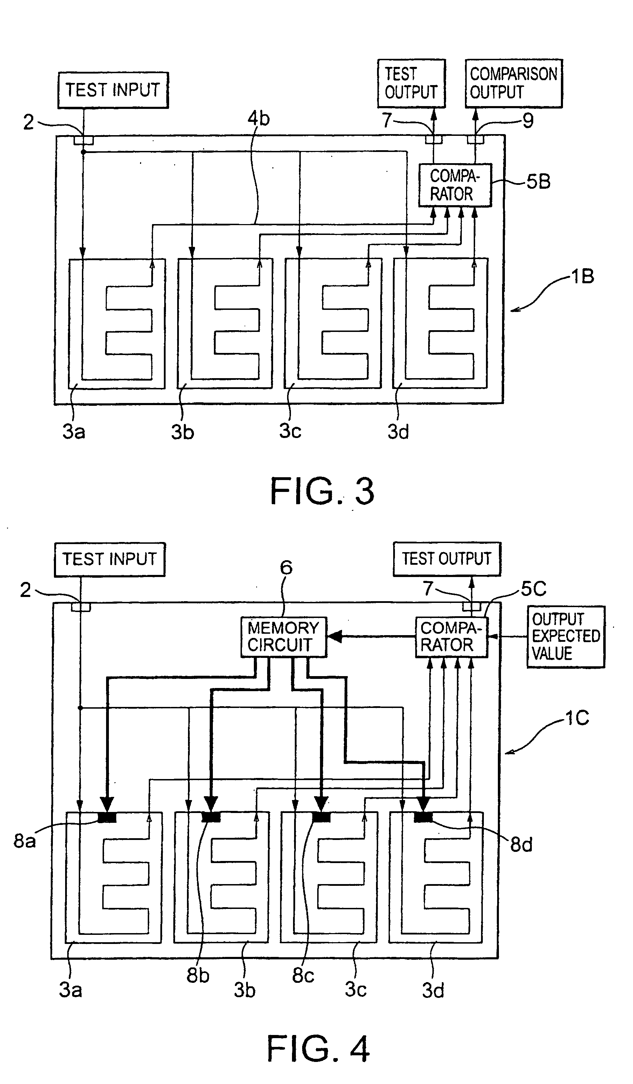

Next, the structure of a semiconductor integrated circuit of the third embodiment of the present invention is shown in Fig. 3. A semiconductor integrated circuit 1B of this embodiment is achieved by replacing the comparator 5 of the semiconductor integrated circuit 1 of the first embodiment shown in Fig. 1 with a comparator 5B, and by newly adding a comparison output terminal 9. The comparator 5B is configured such that the test path output of a selected one of the logic circuits (the logic circuit 3a in Fig. 3) is outputted from the test output terminal 7 as it is, and that the test outputs of the logic circuits 3a, 3b, 3c, and 3d are simultaneously compared, and the comparison result is outputted to the outside through the comparison output terminal 9.

In the semiconductor integrated circuit 1B of this embodiment, an external test device compares the test path outputs and the expected value, and also monitors the comparison outputs. Accordingly, the number of tests can be reduced from two in the first embodiment to one, thereby further reducing the time required for the test. Of course, it is also possible to save the capacity of memory required for storing the test pattern.

### (Fourth Embodiment)

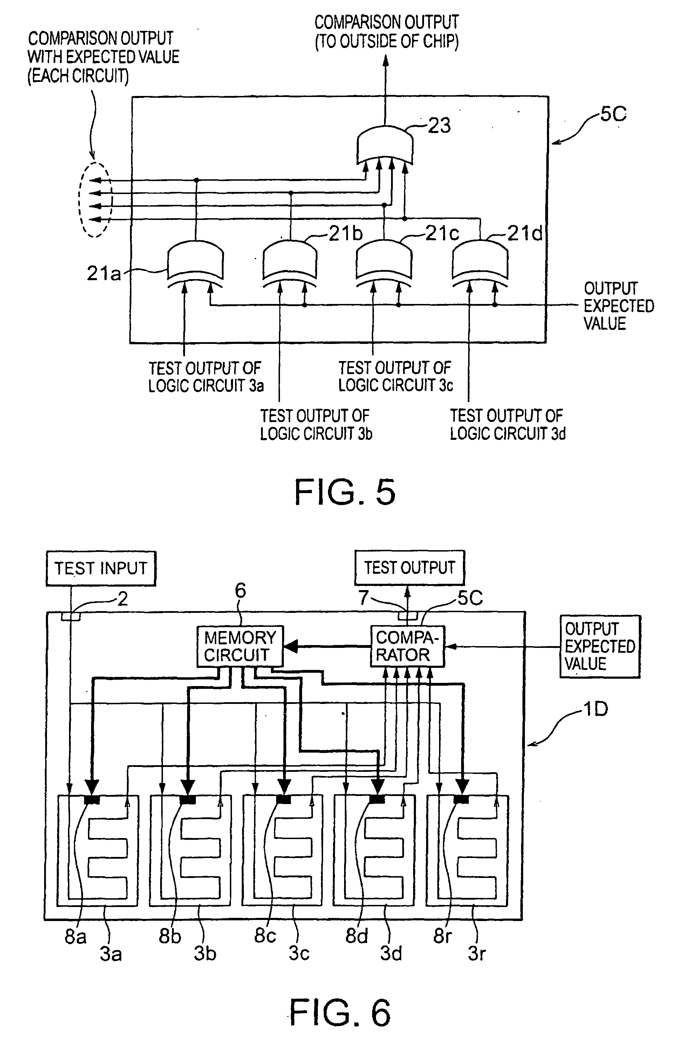

Next, the structure of a semiconductor integrated circuit according to the fourth embodiment not showing all the necessary features of the present invention is shown in Fig. 4. A semiconductor integrated circuit 1C of this embodiment is achieved by replacing the comparator 5 of the semiconductor integrated circuit 1 of the first embodiment shown in Fig. 1 with a comparator 5C, newly adding a memory circuit 6, and providing switching circuits 8a, 8b, 8c, and 8d to the logic circuits 3a, 3b, 3c, and 3d. The comparator 5C compares an output expected value and the test outputs of the logic circuits 3a, 3b, 3c, and 3d, determines whether all of them are the same or not, and outputs the comparison result to the outside via the test output terminal 7, as in the case of the comparator 5A of the second embodiment. Further, the comparator 5C stores the comparison results in the memory circuit 6. Fig. 5 shows an example of the specific structure of the comparator 5C in this embodiment. As shown in Fig. 5, the comparator 5C of this embodiment includes exclusive OR gates 21a, 21b, 21c, and 21d, and an OR gate 23. The exclusive OR gate 21i (i=a, b, c, d) determines whether or not the output expected value and the test output from the logic circuit 3i matches with each other. The outputs of the exclusive OR gates 21a, 21b, 21c, and 21d are sent to the OR gate 23 and also to the memory circuit 6. In addition, the output of the OR gate 23 is sent to the test output terminal 7.

In the first through third embodiments, a comparison is carried out to determine whether or not all of the test outputs match with each other. Accordingly, even if only one logic circuit a failure, the entire chip is determined to be defective.

In order to avoid this, the memory circuit 6 and the switching circuits 8a, 8b, 8c, and 8d are provided in this embodiment. The memory circuit 6 is a nonvolatilememory, whichmonitors the signals sent from the comparator 5C and stores whether any mismatch occurs (i.e., the existence or nonexistence of a failure) for each of the logic circuits 3a, 3b, 3c, and 3d during the test. After the test is finished, what is stored in the memory circuit 6 is outputted to the switching circuits 8a, 8b, 8c, and 8d provided to the logic circuits 3a, 3b, 3c, and 3d. The switching circuits 8a, 8b, 8c, and 8d receives information from the memory circuit 6 on the existence or nonexistence of a failure in the corresponding logic circuits. If there is a failure in any of the logic circuits, the logic circuit is disabled by, for example, stopping the clock signals supplied to the logic circuit.

When a semiconductor integrated circuit includes a logic circuit having a defective portion, the whole chip is determined to be defective in the first to the third embodiment. However, such an integrated circuit may be regarded as a semiconductor integrated circuit including a disabled logic circuit having a defective portion in this embodiment. Accordingly, the semiconductor integrated circuit 1C of this embodiment is effective if the circuits to be tested (for example, logic circuits) are replaceable.

As in the case of the first embodiment, the semiconductor integrated circuit of this embodiment can reduce the time required for the test, and save the capacity of the memory storing the test pattern.

### (Fifth Embodiment)

The structure of a semiconductor integrated circuit according to the fifth embodiment not showing all the necessary features of the present invention is shown in Fig. 6. A semiconductor integrated circuit 1D of this embodiment is achieved by redundantly adding a logic circuit to be tested 3r to the semiconductor integrated circuit 1C of the fourth embodiment shown in Fig. 4. The redundant logic circuit 3r is disabled when there is no defective portion in the other logic circuits 3a, 3b, 3c, and 3d. As a result of a test carried out in the same manner as that for the fourth embodiment shown in Fig. 4, if one of the logic circuits 3a, 3b, 3c, and 3d, e.g., 3a, is defective, the memory circuit 6 disables the logic circuit 3a, in which there is a failure, and activates the redundant logic circuit 3r. When the test is finished, and the semiconductor integrated circuit actually operates, the redundant logic circuit 3r operates as the substitute for the defective logic circuit 3a.

In the fourth embodiment shown in Fig. 4, if a circuit to be tested fails to operate properly, the performance of the entire semiconductor integrated circuit is decreased. However, in the fifth embodiment shown in Fig. 6, if the number of the failed logic circuit is one, the performance of the entire semiconductor circuit is not decreased since the defective logic circuit is replaced with the redundant logic circuit 3r.

Also in this embodiment, it is possible to reduce the time required for the test, and it is possible to save the capacity of the memory storing the test pattern.

### (Sixth Embodiment)

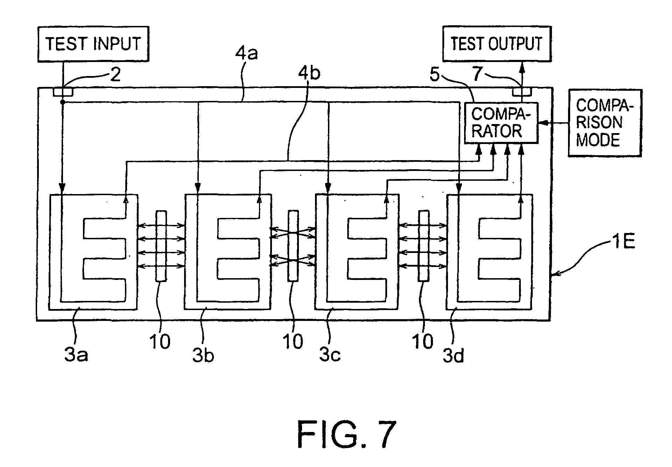

The structure of a semiconductor integrated circuit of the sixth embodiment not showing all the necessary features of the present invention is shown in Fig. 7. A semiconductor integrated circuit 1E of the sixth embodiment is achieved by adding a disconnecting circuit 10 logically disconnecting signals passed between the circuits to be tested during the test operation if there are signal lines connecting the logic circuits 3a, 3b, 3c, and 3d to be tested.

When the logic circuits 3a, 3b, 3c, and 3d are connected with signal lines, and the connection of signal lines between a pair of the logic circuits are different from the connection of signal lines between another pair, there is a case where some logic circuits to be tested operate differently in response to the inputted test pattern. For example, in the case of Fig. 7, assuming that the signal lines are connected in the same manner between the logic circuits 3a and 3b, and between the logic circuits 3c and 3d, but the signal lines are not connected in the same manner between the logic circuits 3b and 3c, when the same test pattern is inputted to all of the logic circuits, the output results differ, although there is no failure in the logic circuits to be tested. In such a case, the comparison of the logic circuits is not simple and easy as in the case of the first embodiment.

In order to solve this problem, the disconnecting circuit 10 logically disconnecting the connections between the logic circuits to be tested is provided as shown in Fig. 7. In this way, the logic circuits 3a, 3b, 3c, and 3d to be tested become logically independent of each other during the test. Thus, it is possible to obtain the same output to be compared for the same input of the test pattern if there is no failure. It should be noted that a disconnecting circuit 8 may be inserted in the same manner as this embodiment to the semiconductor integrated circuits of the second to the fifth embodiments.

In the first to the sixth embodiment described above, the circuits to be tested were logic circuits. However, the present invention can be applied to other circuits than logic circuits.

As described above, according to the present invention, it is possible to reduce the time required for a test as compared with the conventional cases.

Additional advantages and modifications will readily occur to those skilled in the art. Therefore, the invention in its broader aspects is not limited to the specific details and representative embodiments shown and described herein. Accordingly, various modifications may be made without departing from the scope of the invention as defined by the appended claims.

## Claims

1. A semiconductor integrated circuit (1B) comprising:
a plurality of circuits (3a, 3b, 3c, 3d) to be tested, each having the same structure;
test paths (4a, 4b) each provided for one of said circuits (3a, 3b, 3c, 3d) to be tested; and
a comparator (5B) receiving, via said test paths (4a, 4b), test outputs sent from said circuits (3a, 3b, 3c, 3d) to be tested, comparing the test outputs, and determining whether the test outputs match with each other or not, the comparator (5B) comprising a first output terminal (9) to output a result of the comparison and a second output terminal (7) to directly output a test output sent from a predetermined one of said circuits (3a, 3b, 3c, 3d) to be tested.

2. The semiconductor integrated circuit (1B) according to claim 1, wherein said comparator (5B) compares the test outputs sent from said circuits (3a, 3b, 3c, 3d) to be tested with an expected value, and determines whether the test outputs match with the expected value.

3. The semiconductor integrated circuit (1B) according to claim 2, further comprising:
a memory circuit (6) storing comparison results of said comparator (5B) on whether the test outputs sent from said circuits (3a, 3b, 3c, 3d) to be tested match with the expected value or not; and
switching circuits each provided to one of said circuits (3a, 3b, 3c, 3d) to be tested, determining whether at least one of said circuits (3a, 3b, 3c, 3d) to be tested is defective or not based on an output of said memory circuit, and in the case where there is a defective circuit (3a; 3b; 3c; 3d) to be tested, switching the defective circuit (3a; 3b; 3c; 3d) to be tested so as to be disabled.

4. The semiconductor integrated circuit (1B) according to claim 3, further comprising a redundant circuit (3r) having the same structure as said circuits (3a, 3b, 3c, 3d) to be tested, wherein said redundant circuit (3r) is substituted for the circuit (3a; 3b; 3c; 3d) to be tested, which is determined to be defective during the test.

5. The semiconductor integrated circuit (1B) according to claim 1, further comprising a disconnecting circuit logically disconnecting the connection between any two of said circuits (3a, 3b, 3c, 3d) to be tested during the test.

## Patentansprüche

1. Integriert Halbleiterschaltung (1B), umfassend:
eine Vielzahl von zu prüfenden Schaltkreisen (3a, 3b, 3c, 3d), von denen jeder dieselbe Struktur hat;
jeweils für einen der zu testenden Schaltkreise (3a, 3b, 3c, 3d) vorgesehene Prüfpfade (4a, 4b);
einen Komparator (5B), der über die Prüfpfade. (4a, 4b) von den zu testenden Schaltkreisen (3a, 3b, 3c, 3d) gesendete Prüfausgangsgrößen empfängt, die Prüfausgangsgrößen vergleicht, und bestimmt, ob die Prüfausgangsgrößen miteinander übereinstimmen oder nicht, wobei der Komparator (5B) einen ersten Ausganganschluss (9) umfasst zum Ausgeben eines Ergebnisses der Prüfung und einen zweiten Ausgangsanschluss (7) zum direkten Ausgeben einer von einem vorbestimmten der zu testenden Schaltkreise (3a, 3b, 3c, 3d) gesendeten Prüfausgangsgröße.

2. Integrierte Halbleiterschaltung (1B) nach Anspruch 1, wobei der Komparator (5B) die von den zu prüfenden Schaltkreisen (3a, 3b, 3c, 3d) gesendeten Prüfausgangsgrößen mit einem erwarteten Wert vergleicht, und bestimmt, ob die Prüfausgangsgrößen mit den erwarteten Wert übereinstimmen.

3. Integrierte Halbleiterschaltung (1B) nach Anspruch 2, außerdem umfassend:
einen Speicherschaltkreis (6), der Vergleichsergebnisse des Komparators (5B) in Bezug darauf, ob die von den zu prüfenden Schaltkreisen (3a, 3b, 3c, 3d) gesendeten Prüfausgangsgrößen mit dem erwarteten Wert übereinstimmen, speichert;
Schaltschaltkreise von denen jeder für einen zu prüfenden Schaltkreis (3a, 3b, 3c, 3d) vorgesehen ist, bestimmend, ob mindestens einer der zu prüfenden Schaltkreise (3a, 3b, 3c, 3d) defekt ist oder nicht basierend auf einer Ausgangsgröße des Speicherschaltkreises, und in dem Fall, in dem es einen defekten zu prüfenden Schaltkreis (3a; 3b; 3c; 3d) gibt, den defekten zu prüfenden Schaltkreis (3a; 3b; 3c; 3d) schaltend, damit er unwirksam ist.

4. Integrierte Halbleiterschaltung (1B) nach Anspruch 3, außerdem einen Resonanzschaltkreis (3r) umfassend mit der selben Struktur wie die zu prüfenden Schaltkreise (3a, 3b, 3c, 3d), wobei der Resonanzschaltkreis (3r) den zu prüfenden Schaltkreis (3a; 3b; 3c; 3d) ersetzt, der während der Prüfung als defekt bestimmt worden ist.

5. Integrierte Halbleiterschaltung (1B) nach Anspruch 1, ferner einen die Verbindung zwischen irgendwelchen zwei der zu prüfenden Schaltkreise (3a, 3b, 3c, 3d) während der Prüfung logisch trennenden Trennschaltkreis umfassend.

## Revendications

1. Circuit intégré à semiconducteur (1B) comprenant :
une pluralité de circuits (3a, 3b, 3c, 3d) à tester, ayant chacun la même structure ;
des chemins de tests (4a, 4b) chacun fournis pour un desdits circuits (3a, 3b, 3c, 3d) à tester ; et
un comparateur (5B) recevant, via lesdits chemins de test (4a, 4b), des sorties de test envoyées à partir desdits circuits (3a, 3b, 3c, 3d) à tester, comparant les sorties de test, et détermination si les sorties de test correspondent les unes aux autres ou non, le comparateur (5B) comprenant une première borne de sortie (9) pour fournir un résultat de la comparaison et une seconde borne de sortie (7) pour directement fournir une sortie de test envoyée à partir d'un desdits circuits prédéterminés (3a, 3b, 3c, 3d) à tester.

2. Circuit intégré à semiconducteur (1B) selon la revendication 1, dans lequel ledit comparateur (5B) compare les sorties de test envoyées à partir desdits circuits (3a, 3b, 3c, 3d) à tester à une valeur attendue, et détermine si les sorties de test correspondent à la valeur attendue.

3. Circuit intégré à semiconducteur (1B) selon la revendication 2, comprenant en outre :
un circuit de mémoire (6) stockant les résultats de comparaison dudit comparateur (5B) selon que les sorties de test envoyées par lesdits circuits (3a, 3b, 3c, 3d) à tester correspondent à la valeur attendue ou non ; et
des circuits de commutation fournis chacun à un desdits circuits (3a, 3b, 3c, 3d) à tester, déterminant si au moins un desdits circuits (3a, 3b, 3c, 3d) à tester est défectueux ou non sur la base d'une sortie dudit circuit de mémoire, et dans le cas où il y a un circuit défectueux (3a, 3b, 3c, 3d) à tester, commutant le circuit défectueux (3a, 3b, 3c, 3d) à tester afin d'être invalidé.

4. Circuit intégré à semi-conducteur (1B) selon la revendication 3, comprenant en outre un circuit redondant (3r) ayant la même structure que lesdits circuits (3a, 3b, 3c, 3d) à tester, dans lesquels ledit circuit redondant (3r) est substitué par le circuit (3a, 3b, 3c, 3d) à tester, qui est déterminé être défectueux pendant le test.

5. Circuit intégré à semi-conducteur (1B) selon la revendication 1, comprenant en outre un circuit de déconnexion déconnectant logiquement la connexion entre l'un quelconque de deux desdits circuits (3a, 3b, 3c, 3d) à tester pendant le test.
